# FASCICULE DE BREVET EUROPEEN

(11) **EP 3 698 442 B1**
(45) Date de publication et mention de la délivrance du brevet: **15.09.2021**
(21) Numéro de dépôt: 17842359.6
(22) Date de dépôt: 19.10.2017
(51) Int. Cl.: H01S 5/10, H01S 5/34

(54) **STRUCTURE COMPRENANT UNE COUCHE SEMICONDUCTRICE CONTRAINTE SUR UN DISSIPATEUR THERMIQUE**
STRUKTUR MIT EINER VERSPANNTEN HALBLEITERSCHICHT AUF EINEM KÜHLKÖRPER
STRUCTURE COMPRISING A SEMICONDUCTOR STRAINED-LAYER ON A HEAT SINK

(43) Date de publication de la demande: 26.08.2020
(73) Titulaire: STMicroelectronics Crolles 2 SAS, 38920 Crolles (FR); Centre National de la Recherche Scientifique, 75794 Paris Cedex 16 (FR); Université Paris-Saclay, 91190 Saint-Aubin (FR)
(72) Inventeur: ELBAZ, Anas, 77176 Savigny Le Temple (FR); EL KURDI, Moustafa, 94230 Cachan (FR); AASSIME, Abdelhanin, 91310 Monthlhery (FR); BOUCAUD, Philippe, 75013 Paris (FR); BOEUF, Frédéric, 38420 Le Versoud (FR)
(74) Mandataire: Cabinet Beaumont
(86) Numéro de dépôt international: PCT/FR2017/052881
(87) Numéro de publication internationale: WO 2019/077210

(56) Documents cités:
- WO-A1-2016/142588
- GHRIB A ET AL: "All-Around SiN Stressor for High and Homogeneous Tensile Strain in Germanium Microdisk Cavities", ADVANCED OPTICAL MATERIALS WILEY-VCH GERMANY, vol. 3, no. 3, mars 2015 (2015-03), pages 353-358, XP002782689, ISSN: 2195-1071 cité dans la demande

## Description

### Domaine

La présente demande concerne une structure comprenant une couche semiconductrice contrainte comprenant au moins du germanium.

### Exposé de l'art antérieur

Le germanium contraint et les alliages contraints de germanium et d'un ou plusieurs autres composés semiconducteurs sont typiquement utilisés dans le domaine de l'optoélectronique, et, plus particulièrement, dans la fabrication de lasers, de guides d'onde. Ils sont également utilisés en microélectronique pour la réalisation de transistors de type CMOS.

Il existe différents procédés pour obtenir du germanium contraint, l'un d'entre eux consiste à enfermer une couche de germanium entre deux couches de nitrure de silicium contraintes. Ce procédé est décrit dans l'article intitulé "All-Around SiN Stressor for High and Homogeneous Tensile Strain in Germanium Microdisk Cavities" de Abdelhamid Ghrib et al. paru en mars 2015 dans la revue Advanced Optical Materials, volume 3, p. 353 à 358.

Il serait souhaitable de pouvoir améliorer, au moins en partie, certains aspects des structures connues permettant de contraindre du germanium ou par exemple un alliage de germanium et d'étain.

### Résumé

Un mode de réalisation prévoit une structure comprenant, sur un support semiconducteur, une portion d'une couche semiconductrice, ou d'un empilement de couches semiconductrices, comprenant du germanium, et une couche de nitrure de silicium entourant et appliquant une contrainte sur la portion,
dans laquelle le support semiconducteur est séparé de la couche en nitrure de silicium par un pied métallique.

Selon un mode de réalisation, le pied en métal est en aluminium ou en un composé d'aluminium et de silicium.

Selon un mode de réalisation, la couche semiconductrice ou chacune des couches semiconductrices de l'empilement de couches semiconductrices est en germanium, en germanium-étain ou en silicium-germanium-étain.

Selon un mode de réalisation, ladite portion est un résonateur d'un laser.

Selon un mode de réalisation, ladite portion est un guide d'onde.

Selon un mode de réalisation, le pied en métal a une hauteur supérieure à 600 nm.

Selon un mode de réalisation, ladite portion a une épaisseur comprise entre 200 et 500 nm.

Selon un mode de réalisation, la couche de nitrure de silicium a une épaisseur comprise entre 200 et 700 nm.

Selon un mode de réalisation, le pied en métal est fixé au support semiconducteur par l'intermédiaire d'un empilement de couches de fixation.

Selon un mode de réalisation, dans laquelle l'empilement de couches de fixation a une hauteur de l'ordre de 100 nm.

Selon un mode de réalisation, l'empilement de couches de fixation comprend deux couches en oxyde de silicium.

Selon un mode de réalisation, l'empilement de couches de fixation comprend deux couches en or et une couche anti-diffusion.

Selon un mode de réalisation, la couche anti-diffusion est en oxyde de silicium ou en nitrure de silicium.

Un autre mode de réalisation prévoit un procédé de fabrication d'une structure comprenant les étapes successives suivantes :
former sur une face d'un premier support semiconducteur une pile de couches comprenant successivement :
   une portion d'une couche semiconductrice ou d'un empilement de couches semiconductrices, comprenant du germanium ;
   une première couche en nitrure de silicium ; et
   une couche en métal contraignant la première couche en nitrure de silicium,
coller une face d'un deuxième support semiconducteur à la couche de métal, et séparer la pile du premier support ;
graver sélectivement la couche de métal pour réduire sa largeur par rapport à la dimension latérale de la première couche de nitrure de silicium ; et
déposer de façon isotrope une deuxième couche de nitrure de silicium sur la couche semiconductrice (30).

Selon un mode de réalisation, le deuxième support semiconducteur est collé à la couche métallique par un collage par thermocompression ou par un collage moléculaire.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe d'une structure comprenant une couche semiconductrice contrainte ;
la figure 2 est une vue en coupe d'un mode de réalisation d'une structure comprenant une couche semiconductrice contrainte ; et
les figures 3A à 3F sont des vues en coupe d'un procédé de fabrication de la structure de la figure 2.

### Description détaillée

De mêmes éléments ont été désignés par de mêmes références dans les différentes figures. Par souci de clarté, seuls les éléments utiles à la compréhension des modes de réalisation décrits ont été représentés et sont détaillés.

Dans la description qui suit, lorsque l'on fait référence à des qualificatifs de position relative, tels que les termes "dessus", "supérieur", "inférieur", etc., il est fait référence à l'orientation de l'élément concerné dans les figures. Sauf précision contraire, l'expression "de l'ordre de" signifie à 10 % près, de préférence à 5 % près.

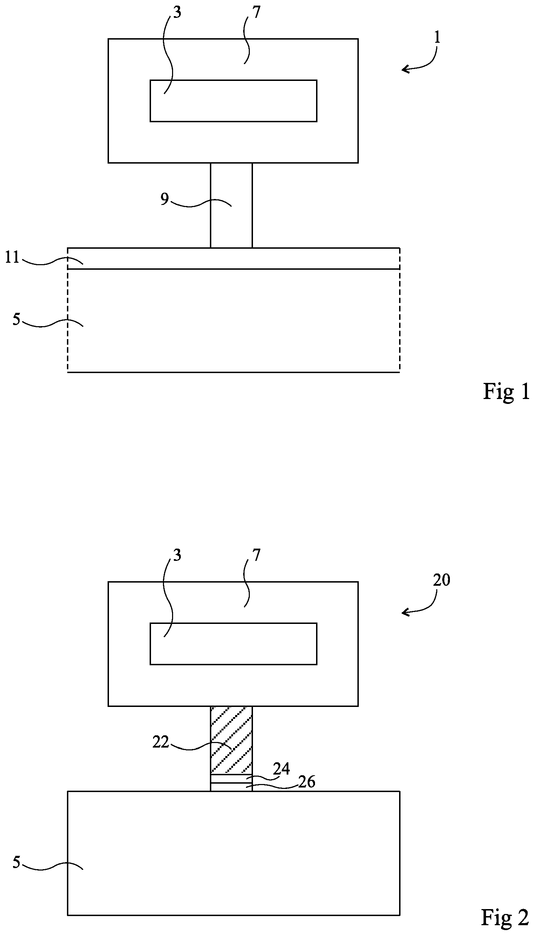

La figure 1 est une vue en coupe d'une structure 1 comprenant une couche semiconductrice contrainte, comprenant du germanium, décrite dans l'article mentionné précédemment dans l'exposé de l'art antérieur.

La structure 1 comprend une portion d'une couche semiconductrice contrainte 3 comprenant du germanium disposée au-dessus d'un support semiconducteur 5, par exemple en silicium. La portion de couche 3 est entourée d'une couche de nitrure de silicium 7 contrainte. La couche 7 contraint la portion de couche 3. La couche 7 a une épaisseur du même ordre de grandeur que celle de la portion de couche 3. La portion de couche 3 et la couche 7 sont séparées du support semiconducteur 5 par un pied en oxyde de silicium 9. En vue de dessus, le pied 9 a une taille inférieure à celle de la portion de couche 3. La face supérieure du support 5 est par exemple recouverte d'oxyde de silicium 11 en contact avec le pied 9. En pratique, ce type de structure est formé dans et sur une structure de type SOI (de l'anglais "Silicon On Insulator"), dans laquelle le pied 9 est formé à partir de la couche isolante enterrée BOX (de l'anglais "Buried Oxide").

La figure 2 est une vue en coupe d'un mode de réalisation d'une structure 20 comprenant du germanium contraint. La structure 20 est identique à la structure 1 de la figure 1 à la différence que le pied en oxyde de silicium 9 de la figure 1 est remplacé par un pied métallique 22.

A titre d'exemple, la portion de couche 3 est en germanium ou en un alliage de germanium et d'un ou plusieurs composés, par exemple un alliage de germanium et d'étain ou un alliage de germanium, de silicium et d'étain. La portion de couche 3 a une épaisseur comprise par exemple entre 200 et 500 nm, par exemple de l'ordre de 350 nm. A titre de variante, la portion de couche 3 peut être une portion d'un empilement de couches comprenant du germanium. La portion de couche 3 peut correspondre à un micro disque servant de résonateur pour un laser, par exemple un laser germanium-étain, à un guide d'onde ou encore à être une couche à puits quantiques multiples formés par exemple dans un guide d'onde ou dans un microdisque.

La couche de nitrure de silicium 7 a une épaisseur de l'ordre de celle de la portion de couche 3. La couche de nitrure de silicium contraint la portion de couche 3. A titre d'exemple, la couche 7 a une épaisseur comprise entre 200 et 700 nm, par exemple de l'ordre de 450 nm.

Le pied métallique 22 est par exemple en aluminium ou en un composé d'aluminium et de silicium. Le pied 22 a par exemple une hauteur minimale de l'ordre de 600 nm. Le pied métallique 22 est fixé sur le support 5 par un collage par thermocompression ou par un collage moléculaire. Le collage moléculaire est un collage entre une couche d'oxyde de silicium et une autre couche d'oxyde de silicium, la face supérieure du support 5 est recouverte d'une couche 26 en oxyde de silicium et la face inférieure du pied 22 est recouverte d'une couche 24 en oxyde de silicium. Dans le cas d'un collage or-or, la face supérieure du support 5 est recouverte d'une couche 26 en or et la face inférieure du pied 22 est recouverte d'une couche 24 en or. Cependant, pour éviter la diffusion d'atomes d'or dans le pied métallique 22, la couche 24 est séparée du pied 22 par une couche anti-diffusion (non représenté en figure 2), par exemple en nitrure de silicium ou en oxyde de silicium. Dans le cas d'un assemblage or-or, l'assemblage des couches 26 et 24 a par exemple une hauteur de l'ordre de 100 nm et pouvant aller par exemple jusqu'à 1 µm et la couche anti-diffusion a une hauteur maximale de 150 nm. Dans le cas d'un collage entre oxyde de silicium, l'assemblage des couches 26 et 24 a par exemple une hauteur de l'ordre de 100 nm et pouvant aller par exemple jusqu'à 2 µm.

Un avantage de ce mode de réalisation est que le matériau du pied 22 est un meilleur conducteur thermique que l'oxyde de silicium. Ceci permet de dissiper la chaleur produite dans la portion de couche 3 vers le support semiconducteur 5 pendant l'utilisation de la structure 20. Ceci est plus particulièrement utile lorsque la portion de couche 3 est utilisée comme zone émettrice dans un résonateur pour réaliser un laser.

Un autre avantage de ce mode de réalisation est que le pied en aluminium ou en un alliage d'aluminium et de silicium conserve les mêmes propriétés qu'un pied en oxyde de silicium, par exemple en ce qui concerne le transfert de déformation.

Encore un autre avantage de ce mode de réalisation est qu'il est possible de créer des contacts électriques traversant le pied 22.

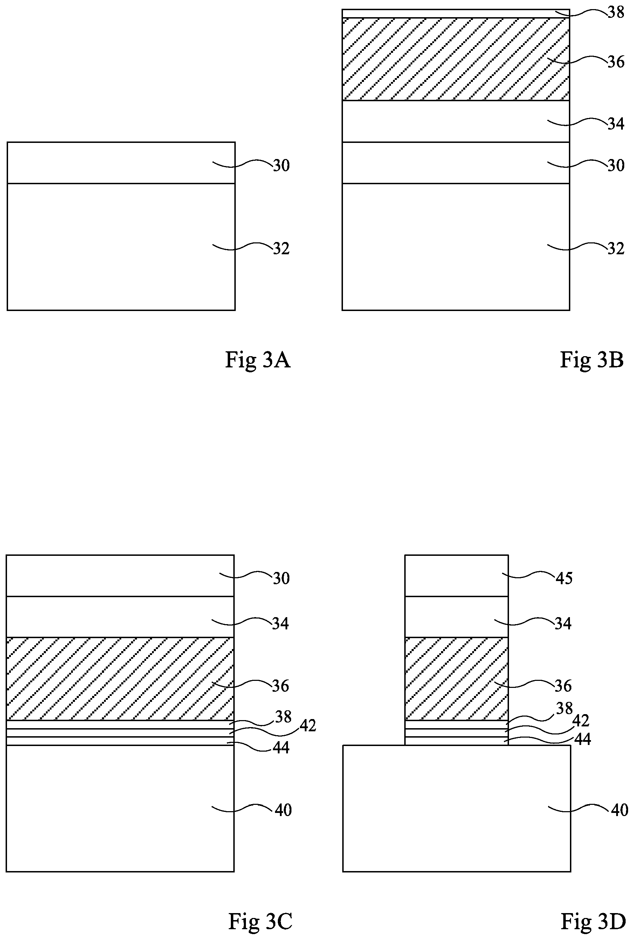

Les figures 3A à 3F sont des vues en coupe d'étapes d'un mode de réalisation d'un procédé de fabrication d'une structure du type de la structure 20 de la figure 2.

A l'étape de la figure 3A, une couche semiconductrice 30 en germanium ou en un alliage de germanium et d'un ou plusieurs composés est formée sur un support semiconducteur 32, par exemple en silicium. La couche 30 est par exemple formée par épitaxie. La couche 30 a par exemple une épaisseur comprise entre 200 et 500 nm.

A l'étape de la figure 3B, une couche de nitrure de silicium 34 est déposée sur la couche semiconductrice 30. La couche de nitrure de silicium a une épaisseur de l'ordre de celle de couche 30, par exemple comprise entre 200 et 700 nm. Une couche métallique 36 est déposée sur la couche de nitrure de silicium 34. La couche métallique 36 est susceptible d'appliquer une contrainte sur la couche de nitrure de silicium 34. La couche métallique 36 est par exemple en aluminium, ou en un composé d'aluminium et de silicium. La couche métallique 36 a par exemple une épaisseur supérieure à 600 nm. On considère ici un collage or-or et une couche anti-diffusion 38 est déposée sur la couche métallique 36.

A l'étape de la figure 3C, la structure de la figure 3B est retournée puis collée sur un support semiconducteur 40. Pour cela, la face libre de la couche anti-diffusion 38 et la couche supérieure du support 40 sont recouvertes d'une couche d'or puis positionnées l'une sur l'autre, on parle de collage moléculaire. L'empilement, ou pile, comprenant la couche semiconductrice 30, la couche de nitrure de silicium 34, la couche métallique 36 et la couche anti-diffusion 38 est ensuite séparé du support 32 pour laisser une face de la couche semiconductrice 30 libre. L'ensemble comprenant la couche anti-diffusion 38 et les couches d'or 42 et 44 est appelé ci-après empilement de fixation.

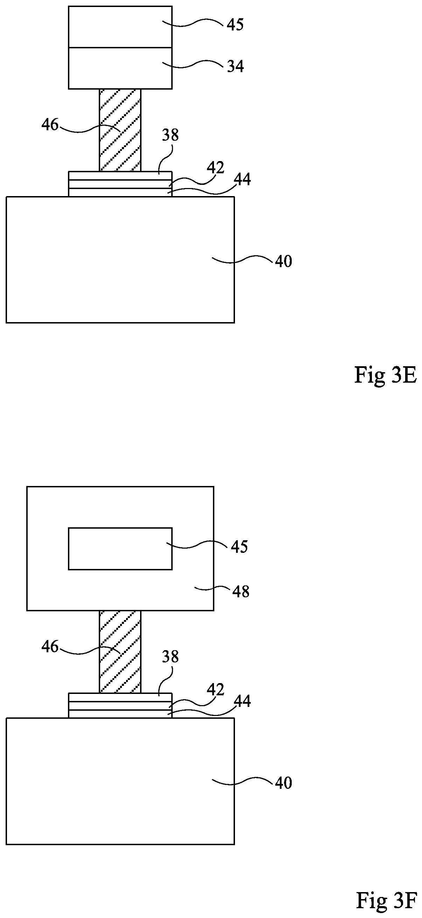

A l'étape de la figure 3D, la couche 30 subit diverses étapes de modification (non décrites ici) comme par exemple des étapes de gravures, de dopages, etc., pour devenir une portion de couche 45. Ces étapes de modification permettent notamment de donner à la portion de couche semiconductrice 30 la forme nécessaire à sa future utilisation. A titre d'exemple, ces étapes de modification sont représentées en figure 3 par une étape de gravure donnant une forme particulière à la portion de couche 45, par exemple une forme circulaire. La couche de nitrure de silicium 34, la couche métallique 36 et l'empilement de fixation peuvent subir également cette étape de gravure.

A l'étape de la figure 3E, la couche métallique 36 est gravée sélectivement par rapport aux autres couches pour former un pied métallique 46. Le pied métallique 46 a un diamètre inférieur à celui de la portion de couche 45. En réduisant la taille du contact entre le métal du pied 46 et la couche de nitrure de silicium 34, la contrainte infligée par le pied 46 sur la couche 34 est également réduite et la couche 34 se relaxe. En se relaxant, la couche 34 applique elle-même une contrainte sur la portion de couche 45.

A l'étape de la figure 3F, un dépôt isotrope de nitrure de silicium contraint est effectué sur la portion de couche 45. Ce dépôt isotrope peut être effectué de façon sélective. Ce dépôt permet la formation, à partir de la couche 34, d'une couche de nitrure de silicium 48 entourant et contraignant la portion de couche 45. A titre d'exemple, ce dépôt est un dépôt chimique en phase vapeur assisté par plasma.

Des modes de réalisation particuliers ont été décrits. Diverses variantes et modifications apparaîtront à l'homme de l'art. En particulier, la portion de couche 3 peut être une portion d'un empilement de couches semiconductrices.

## Revendications

1. Structure comprenant, sur un support semiconducteur (5), une portion (3) d'une couche semiconductrice, ou d'un empilement de couches semiconductrices, comprenant du germanium, et une couche de nitrure de silicium (7) entourant et appliquant une contrainte sur la portion (3),
dans laquelle le support semiconducteur (5) est séparé de la couche en nitrure de silicium (7) par un pied métallique (22).

2. Structure selon la revendication 1, dans laquelle le pied en métal (22) est en aluminium ou en un composé d'aluminium et de silicium.

3. Structure selon la revendication 1 ou 2, dans laquelle la couche semiconductrice ou chacune des couches semiconductrices de l'empilement de couches semiconductrices est en germanium, en germanium-étain ou en silicium-germanium-étain.

4. Structure selon l'une quelconque des revendications 1 à 3, dans laquelle ladite portion (3) est un résonateur d'un laser.

5. Structure selon l'une quelconque des revendications 1 à 3, dans laquelle ladite portion (3) est un guide d'onde.

6. Structure selon l'une quelconque des revendications 1 à 5, dans laquelle le pied en métal (22) a une hauteur supérieure à 600 nm.

7. Structure selon l'une quelconque des revendications 1 à 6, dans laquelle ladite portion (3) a une épaisseur comprise entre 200 et 500 nm.

8. Structure selon l'une quelconque des revendications 1 à 7, dans laquelle la couche de nitrure de silicium (7, 48) a une épaisseur comprise entre 200 et 700 nm.

9. Structure selon l'une quelconque des revendications 1 à 8, dans laquelle le pied en métal (22) est fixé au support semiconducteur (5) par l'intermédiaire d'un empilement de couches de fixation.

10. Structure selon la revendication 9, dans laquelle l'empilement de couches de fixation a une hauteur de l'ordre de 100 nm.

11. Structure selon la revendication 9 ou 10, dans laquelle l'empilement de couches de fixation comprend deux couches en oxyde de silicium (24, 26).

12. Structure selon la revendication 9 ou 10, dans laquelle l'empilement de couches de fixation comprend deux couches en or (24, 26, 42, 44) et une couche anti-diffusion (38).

13. Structure selon la revendication 12, dans laquelle la couche anti-diffusion (38) est en oxyde de silicium ou en nitrure de silicium.

14. Procédé de fabrication d'une structure (20) comprenant les étapes successives suivantes :
former sur une face d'un premier support (32) semiconducteur une pile de couches comprenant successivement :
une portion (30) d'une couche semiconductrice ou d'un empilement de couches semiconductrices, comprenant du germanium ;
une première couche en nitrure de silicium (34) ; et
une couche en métal (36) contraignant la première couche en nitrure de silicium (34),
coller une face d'un deuxième support semiconducteur (40) à la couche de métal (36), et séparer la pile du premier support (32) ;
graver sélectivement la couche de métal (36) pour réduire sa largeur par rapport à la dimension latérale de la première couche de nitrure de silicium (34) ; et
déposer de façon isotrope une deuxième couche de nitrure de silicium (48) sur la couche semiconductrice (30).

15. Procédé selon la revendication 14, dans lequel le deuxième support semiconducteur (40) est collé à la couche métallique (36) par un collage par thermocompression ou par un collage moléculaire.

## Patentansprüche

1. Struktur, die auf einem Halbleiterträger (5) einen Teil (3) einer Halbleiterschicht oder eines Stapels von Halbleiterschichten, die Germanium enthalten, und eine Siliziumnitridschicht (7), die den Teil (3) umgibt und belastet, aufweist,
wobei der Halbleiterträger (5) von der Siliziumnitridschicht (7) durch einen Metallfuß (22) getrennt ist.

2. Struktur nach Anspruch 1, wobei der Metallfuß (22) aus Aluminium oder aus einer Verbindung von Aluminium und Silizium besteht.

3. Struktur nach Anspruch 1 oder 2, wobei die Halbleiterschicht oder jede der Halbleiterschichten des Stapels von Halbleiterschichten aus Germanium, aus Germanium-Zinn oder aus Silizium-Germanium-Zinn besteht.

4. Struktur nach einem der Ansprüche 1 bis 3, wobei der Teil (3) ein Resonator für einen Laser ist.

5. Struktur nach einem der Ansprüche 1 bis 3, wobei der Teil (3) ein Wellenleiter ist.

6. Struktur nach einem der Ansprüche 1 bis 5, wobei der Metallfuß (22) eine Höhe von mehr als 600 nm aufweist.

7. Struktur nach einem der Ansprüche 1 bis 6, wobei der Teil (3) eine Dicke im Bereich von 200 bis 500 nm aufweist.

8. Struktur nach einem der Ansprüche 1 bis 7, wobei die Siliziumnitridschicht (7, 48) eine Dicke im Bereich von 200 bis 700 nm aufweist.

9. Struktur nach einem der Ansprüche 1 bis 8, wobei der Metallfuß (22) über einen Stapel von Verbindungsschichten mit dem Halbleiterträger (5) verbunden ist.

10. Struktur nach Anspruch 9, wobei der Stapel von Verbindungsschichten eine Höhe in der Größenordnung von 100 nm aufweist.

11. Struktur nach Anspruch 9 oder 10, wobei der Stapel von Verbindungsschichten zwei Siliziumoxidschichten (24, 26) aufweist.

12. Struktur nach Anspruch 9 oder 10, wobei der Stapel von Verbindungsschichten zwei Goldschichten (24, 26, 42, 44) und eine Antidiffusionsschicht (38) aufweist.

13. Struktur nach Anspruch 12, wobei die Antidiffusionsschicht (38) aus Siliziumoxid oder aus Siliziumnitrid besteht.

14. Verfahren zur Herstellung einer Struktur (20), das die folgenden aufeinanderfolgenden Schritte aufweist:
Ausbilden eines Stapels von Schichten auf einer Oberfläche eines ersten Halbleiterträgers (32), der nacheinander Folgendes umfasst:
einen Teil (30) einer Halbleiterschicht oder eines Stapels von Halbleiterschichten, der Germanium enthält;
eine erste Siliziumnitridschicht (34); und
eine Metallschicht (36), die die erste Siliziumnitridschicht (34) belastet,
Binden einer Oberfläche eines zweiten Halbleiterträgers (40) an die Metallschicht (36) und Trennen des Stapels von dem ersten Träger (32);
selektives Ätzen der Metallschicht (36) zur Verringerung ihrer Breite in Bezug auf die seitliche Abmessung der ersten Siliziumnitridschicht (34); und
isotropes Abscheiden einer zweiten Siliziumnitridschicht (48) auf der Halbleiterschicht (30).

15. Verfahren nach Anspruch 14, wobei der zweite Halbleiterträger (40) mit der Metallschicht (36) durch eine Thermokompressionsbindung oder durch eine molekulare Bindung verbunden wird.

## Claims

1. A structure comprising, on a semiconductor support (5), a portion (3) of a semiconductor layer, or of a stack of semiconductor layers, comprising germanium, and a silicon nitride layer (7) surrounding and straining the portion (3),
wherein the semiconductor support (5) is separated from the silicon nitride layer (7) by a metal foot (22).

2. The structure according to claim 1, wherein the metal foot (22) is made of aluminum or of a compound of aluminum and of silicon.

3. The structure according to claim 1 or 2, wherein the semiconductor layer or each of the semiconductor layers of the stack of semiconductor layers is made of germanium, of germanium-tin, or of silicon-germanium-tin.

4. The structure according to any of claims 1 to 3, wherein said portion (3) is a resonator of a laser.

5. The structure according to any of claims 1 to 3, wherein said portion (3) is a waveguide.

6. The structure according to any of claims 1 to 5, wherein the metal foot (22) has a height greater than 600 nm.

7. The structure according to any of claims 1 to 6, wherein said portion (3) has a thickness in the range from 200 to 500 nm.

8. The structure according to any of claims 1 to 7, wherein the silicon nitride layer (7, 48) has a thickness in the range from 200 to 700 nm.

9. The structure according to any of claims 1 to 8, wherein the metal foot (22) is bonded to the semiconductor support (5) via a stack of bonding layers.

10. The structure according to claim 9, wherein the stack of bonding layers has a height in the order of 100 nm.

11. The structure according to claim 9 or 10, wherein the stack of bonding layers comprises two silicon oxide layers (24, 26).

12. The structure according to claim 9 or 10, wherein the stack of bonding layers comprises two gold layers (24, 26, 42, 44) and an anti-diffusion layer (38).

13. The structure according to claim 12, wherein the anti-diffusion layer (38) is made of silicon oxide or of silicon nitride.

14. A method of manufacturing a structure (20) comprising the successive steps of:
forming on a surface of a first semiconductor support (32) a stack of layers successively comprising:
a portion (30) of a semiconductor layer or of a stack of semiconductor layers, comprising germanium;
a first silicon nitride layer (34); and
a metal layer (36) straining the first silicon nitride layer (34),
bonding a surface of a second semiconductor support (40) to the metal layer (36), and separating the stack from the first support (32);
selectively etching the metal layer (36) to decrease its width with respect to the lateral dimension of the first silicon nitride layer (34); and
isotropically depositing a second silicon nitride layer (48) on the semiconductor layer (30).

15. The method according to claim 14, wherein the second semiconductor support (40) is bonded to the metal layer (36) by a thermocompression bonding or by a molecular bonding.
